Europäisches Patentamt

European Patent Office

Office européen des brevets

(19)

(11) Publication number : **0 462 600 B1**

(12) **EUROPEAN PATENT SPECIFICATION**

(45) Date of publication of patent specification :
27.12.95 Bulletin 95/52

(51) Int. Cl.⁶ : **H01L 39/24,** H01J 37/34,
C23C 14/56

(21) Application number : 91110091.5

(22) Date of filing : 19.06.91

(54) Process for preparing superconductive thin films

(30) Priority : 20.06.90 JP 161995/90

(43) Date of publication of application :
27.12.91 Bulletin 91/52

(45) Publication of the grant of the patent :
27.12.95 Bulletin 95/52

(84) Designated Contracting States :
DE FR GB NL

(56) References cited :
IBM TECHNICAL DISCLOSURE BULLETIN, Vol
31, no 9 , February 1989 pages 330-331,
Armonk, NEW YORK,US
APPLIED PHYSICS LETTERS vol. 55, no. 6, 7
August 1980, pages 595-597, New York, US;
C.B. EORN et al. "In situ grown YBa2Cu307-d
thin films from single-target magnetron sput-
tering"
APPLIED PHYSICS LETTERS vol. 55, no. 10, 4
September 1989, pages 1035-1037, New York,
US; Y. KAGEYAMA et al.: "Effect of a decli-
nation angle of substrate position on magnet-
ron sputter deposition from a YBa2Cu3O7-x
target"
PATENT ABSTRACTS OF JAPAN vol. 10, no.
362 (C-389)(2419), 4 December 1989; & JP - A -
61159571 (HITACHI) 19.07.1986
PATENT ABSTRACTS OF JAPAN, VOL 7, NO
34 (C150) 10 FEBRUARY 1983 & JP-A-57 185
974

(73) Proprietor : SUMITOMO ELECTRIC
INDUSTRIES, LTD.
5-33, Kitahama 4-chome,
Chuo-ku
Osaka-shi, Osaka 541 (JP)

(72) Inventor : Itozaki, Hideo, c/o Itami Works
Sumitomo Electric Ind., Ltd.
1-1, Koyakita 1-chome
Itami-shi, Hyogo (JP)
Inventor : Hattori, Hisao, c/o Itami Works
Sumitomo Electric Ind., Ltd.
1-1, Koyakita 1-chome
Itami-shi, Hyogo (JP)
Inventor : Harada, Keizo, c/o Itami Works
Sumitomo Electric Ind., Ltd.
1-1, Koyakita 1-chome
Itami-shi, Hyogo (JP)
Inventor : Matsuura, Takashi, c/o Itami Works
Sumitomo Electric Ind., Ltd.
1-1, Koyakita 1-chome
Itami-shi, Hyogo (JP)

(74) Representative : Grünecker, Kinkeldey,
Stockmair & Schwanhäusser Anwaltssozietät
Maximilianstrasse 58
D-80538 München (DE)

## Description

### FIELD OF THE INVENTION

The present invention relates to a process for preparing thin films of a composite oxide superconductor.

### BACKGROUND OF THE INVENTION

Superconductivity, a phenomena involving an electronic phase transition, has long been observable only at cryogenic temperatures created by cooling with liquid helium In 1986, however, Bednorz and Müller reported that $(LaBa)_2CuO_4$ exhibited superconductivity at 30K. In 1987, Chu and his coworkers reported $YBa_2Cu_3O_y$ that had critical (superconducting transition) temperatures (Tc) on the order of 90K.

Following these discoveries, in 1988 Maeda et al reported bismuth-based composite superconducting materials that had critical temperatures higher than 100K. Since these composite oxide superconducting materials can exhibit superconductivity even if they are cooled with inexpensive liquid nitrogen, renewed interest arose in the potential use of superconductivity technology in commercial applications.

In the early stages of development, composite oxide superconducting materials having high critical temperatures were obtained as sinters by powder metallurgy. However, desired characteristics, particularly critical current density, cannot be obtained with sintered materials. Therefore, extensive research efforts are currently being made to prepare superconductors in thin films.

Thin films of composite oxide superconductors are usually formed on substrates such as those made of single-crystal $SrTiO_3$ or MgO by various evaporation techniques including vacuum evaporation, sputtering and MBE (molecular beam epitaxy). Of these techniques, sputtering is the most commonly employed method. An example of a sputtering device is given in Patent Abstracts of Japan vol. 7 no 34 (C150) 10 February 1983 & JP-A-57185974. For example, the report given by C.B. Eom et al in Applied Physics Letters, vol.55, (1989) no.6 pages 595-597, discusses a single-target off-axis sputter deposition process for depositing a thin film of superconducting material composed of Y, Ba, Cu and O. Here, the substrate is placed on the side of the magnetron gun vertically with respect to the target.

From prior art JP-A-57185974 a sputtering technique is shown for depositing thin films on a plurality of substrates.

### SUMMARY OF THE INVENTION

Following the pioneering discoveries described above, much progress has been made in the field of new oxide superconducting materials. In addition to reports that verify superconducting characteristics of various oxides, many proposals on the configurations of devices and circuits that use them have been published. Therefore, a need has arisen for a consistent supply of oxide superconducting thin films having uniform characteristics. Thus, it has become necessary to consider thin films of oxide superconductors not only theoretically, but also from the viewpoint of productivity. None of the currently practiced film-forming methods, however, has been capable of simultaneously forming oxide superconducting thin films with uniform characteristics on more than one substrate.

An object of the present invention is to provide a novel process by which superconducting thin films having consistent characteristics can be prepared in an efficient manner.

To attain this and other objects, the present invention provides a process for preparing thin films of a composite oxide superconductor composed of Y, Ba, Cu and O on a plurality of substrates by sputtering, comprising the steps set out in claim 1. The film formation is effected with said plurality of substrates being arranged such that each substrate is disposed normal to the target surface and positioned at the same distance with respect to the target surface.

### BRIEF DESCRIPTION OF THE DRAWING

Fig. 1 shows a schematic arrangement for a sputtering apparatus that can be used to implement the process of the present invention for preparing superconducting thin films by magnetron-assisted sputtering; and

Figs. 2(a) and 2(b) are a plan view and a side view showing the arrangement of substrates with respect to a target shown in Fig. 1, respectively.

DETAILED DESCRIPTION OF THE INVENTION

A principal characteristic of the process of the present invention is in the ability to form superconducting thin films of high quality and homogeneous structure simultaneously on a plurality of substrates.

The assignee of the present invention has already described a process for preparing a thin oxide superconducting film by sputtering a target that is not positioned in a parallel and face-to-face relationship with a substrate (Japanese Patent Application No. Hei. 1-329975). In this previous process, the substrate is intentionally brought out of a parallel and face-to-face relationship with the target, so that the thin film being formed on the substrate will not be adversely affected by secondary electrons or neutral particles emitted from the target.

It is known in sputtering technology that a thin film can be deposited on two differently positioned substrates under the same conditions if the position of each substrate relative to the target is identical. Therefore, if more than one substrate is positioned in such a way that it is not in a parallel and face-to-face relationship with the target, the area of substrate that insures film formation under identical conditions can be expanded compared to the case where a substrate is positioned in a parallel and face-to-face relationship with the target. Taking this approach, the process of the present invention enables oxide superconducting thin films to be simultaneously formed on a plurality of substrates under identical conditions.

According to the present process, a plurality of oxide superconducting thin films of high quality can be formed simultaneously, whereby the rate of their production is markedly improved.

The present process is applicable to all oxide superconductors that can be obtained as thin films by sputtering techniques.

The following example is provided to further illustrate the present invention, but is not to be understood as limiting the technical scope of the present invention in any way.

EXAMPLE

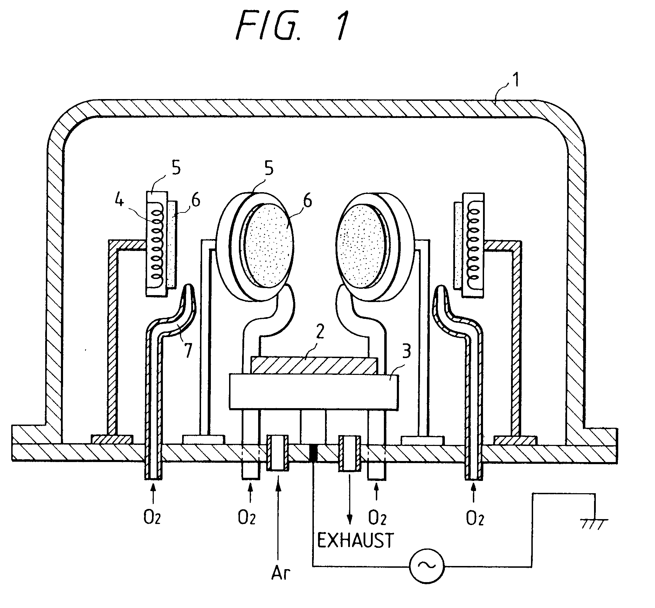

Fig. 1 shows a schematic arrangement for a sputtering apparatus that can be used to implement the process of the present invention for preparing superconducting thin films by magnetron-assisted sputtering. As shown in the Figure, the apparatus comprises a vacuum chamber 1 that accommodates a target 2, a high-frequency electrode 3 which also serves as a holder for the target 2, and a plurality of substrate holders 5 each providing ground level and containing a heater 4. The substrate holders 5 are arranged in such a way that they hold substrates 6 on the side wall of an imaginary cylindrical solid that is defined by projecting the effective area of the target 2 in a direction normal to its surface. Six units of substrate holder 5 are provided at the same height and are properly adjusted to be capable of holding the respective substrates 6 at the same angle with respect to the target 2. Four of such substrate holders are shown in the drawing. The apparatus is also equipped with nozzles 7 that are positioned in such a way that oxygen gas can be blown against the film forming surfaces of the respective substrates 6 retained on the substrate holders 5.

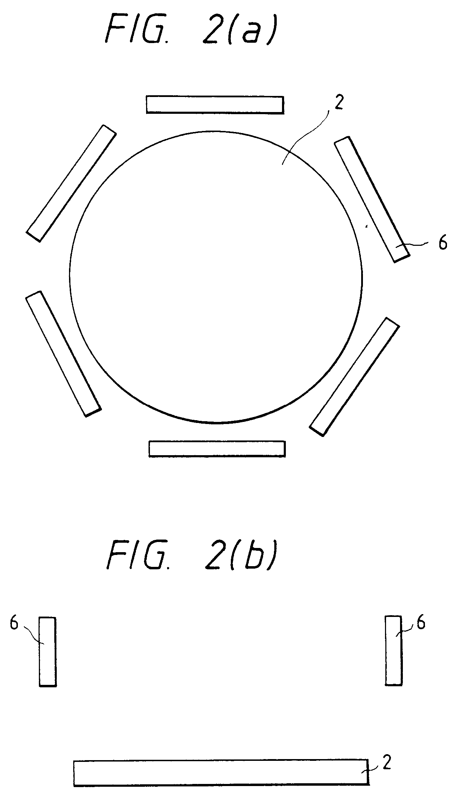

Fig. 2(a) shows the arrangement of the substrates 6 with respect to the target 2 when they are seen from the top of the vacuum chamber 1. Fig. 2(b) shows the arrangement of the substrates when they are seen from the side of the chamber. For example, when the target 2 is a circular plate with a diameter of 10 cm, a diameter of the imaginary cylindrical solid is about 12 cm. Although it is preferable that the substrates are provided at the same height and are positioned parallel to the side wall of the imaginary solid, the substrates may be provided at a different height and simply touch the side wall.

Superconducting thin films were prepared using the sputtering apparatus shown in the drawing. Six single-crystal MgO substrates (20 mm × 20 mm) providing for film formation at (100) faces were set on the associated substrate holders 5 and six samples were prepared. The conditions of film formation used are shown in Table 1 below.

Table 1

| Target composition (Y:Ba:Cu) | 1:2:4 |
|---|---|
| Sputtering gas | $Ar + O_2$ |
| $O_2/(Ar + O_2)$ | 0.2 (volume ratio) |
| Gas pressure | 5.33Pa ($4 \times 10^{-2}$ Torr) |
| Substrate temperature, °C | 650 |
| High-frequency power, W | 50 (0.64 W/cm$^2$) |
| Film thickness | 300nm (3000Å) |

The six samples prepared under the conditions shown above were evaluated for their superconducting characteristics and the results are shown in Table 2.

Table 2

| Sample No. | Critical Temperature*, Tc (°K) | Critical Current Density**, Jc A/cm$^2$ |
|---|---|---|
| 1 | 87 | $2.8 \times 10^6$ |
| 2 | 88 | $3.0 \times 10^6$ |
| 3 | 88 | $3.0 \times 10^6$ |
| 4 | 87 | $2.8 \times 10^6$ |
| 5 | 88 | $3.0 \times 10^6$ |
| 6 | 88 | $3.0 \times 10^6$ |

*Tc refers to the temperature at which the electric resistance of each sample dropped below the detection limit.

**Jc refers to the critical current density at 77 K.

Table 2 shows that all the samples tested exhibited satisfactory superconducting characteristics. Those samples were examined for crystal orientation by X-ray diffraction and each of them was found to be a thin film of good quality having the c-axis aligned in every crystal.

As described above, the process of the present invention is capable of simultaneously forming a plurality of high-quality thin films of a composite oxide superconductor on substrates. Therefore, the present invention enables efficient supply of oxide superconducting thin films that have sufficiently uniform characteristics to be used in research and development efforts on various superconducting devices and circuits.

## Claims

1. A process for preparing thin films of a composite oxide superconductor on a plurality of substrates by sputtering, comprising the steps of:

   preparing said thin films in a mixed gas consisting of argon and oxygen under a pressure of 5.33 Pa and a high-frequency power of 50 W,

   arranging said plurality of substrates such that each substrate is disposed normal to the target surface and

   positioned at the same distance with respect to the target surface, and wherein the target is composed of Y, Ba and Cu; and

   positioning a plurality of nozzles so that each nozzle is close to a respective substrate and blows oxygen gas against the film forming surface of said substrate.

## Patentansprüche

1. Ein Verfahren zur Herstellung von dünnen Filmen aus einem zusammengesetzten Oxidsupraleiter auf einer Mehrzahl von Substraten durch Sputtern, umfassend die Schritte:

   Herstellen der dünnen Filme in einem Mischgas, das Argon und Sauerstoff umfaßt, unter einem Druck von 5,33 Pa und einer Hochfrequenzleistung von 50 W;

   Anordnen der Mehrzahl von Substraten, so daß jedes Substrat normal zu der Targetoberfläche angeordnet und in derselben Entfernung in bezug auf die Targetoberfläche positioniert ist, und in welchem das Target Y, Ba und Cu umfaßt; und

   Positionieren einer Mehrzahl von Düsen, so daß jede Düse in der Nähe eines entsprechenden Substrats ist und Sauerstoffgas gegen die filmbildende Oberfläche des Substrats bläst.

## Revendications

1. Procédé de préparation, par pulvérisation, sur plusieurs substrats, de films minces de supraconducteur composite à oxydes, comprenant les étapes :

   de préparation desdits films minces dans un mélange gazeux constitué d'argon et d'oxygène sous une pression de 5,33 Pa et une puissance à haute fréquence de 50 W ;

   d'agencement desdits plusieurs substrats de façon telle que chaque substrat soit disposé perpendiculairement à la surface de cible et situé à la même distance par rapport à la surface de cible, la cible étant composée de Y, Ba et Cu ; et

   de positionnement de plusieurs buses de sorte que chaque buse soit proche d'un substrat respectif et souffle de l'oxygène gazeux contre la surface de formation de film dudit substrat.

# FIG. 1

# FIG. 2(a)

# FIG. 2(b)